# EUROPEAN PATENT APPLICATION

(11) **EP 2 341 546 A2**
(43) Date of publication of application: **06.07.2011**
(21) Application number: 10016130.6
(22) Date of filing: 28.12.2010
(51) Int. Cl.: H01L 31/0216, H01L 31/0392, H01L 31/052, H01L 31/18

(54) **Solar cell and manufacturing method thereof**

(30) Priority: 29.12.2009 TW 98145634
(71) Applicant: Auria Solar Co., Ltd., Tainan 74146 (TW)
(72) Inventor: Tsai, Chin-Yao, Sinshih Township Tainan 74146 (TW)
(74) Representative: Brandenburger, Karin

(57) **Abstract**

A solar cell including a substrate, a first conductive layer, a photovoltaic layer, a second conductive layer and at least one passivation layer is provided. The first conductive layer is disposed on the substrate. The photovoltaic layer generates electron-hole pairs after receiving light, wherein the photovoltaic layer is disposed on the first conductive layer and has a plurality of doped films. The second conductive layer is disposed on the photovoltaic layer. The passivation layer is disposed onto at least one of the positions between the first conductive layer and the photovoltaic layer, between the doped films within the photovoltaic layer, and between the photovoltaic layer and the second conductive layer, so as to reduce the chance for the electron-hole pairs resulting in recombination on at least one of the surfaces of the photovoltaic layer. A manufacturing method of the solar cell is also provided.

## Description

### BACKGROUND OF THE INVENTION

### Field of the Invention

The present invention relates to a solar cell and a manufacturing method thereof, and more particularly, to a solar cell with an improved photo-electric conversion efficiency and a manufacturing method thereof.

### Descriptions of the Related Art

With rising of the environmental protection awareness, the concept of "energy saving and carbon dioxide emission reduction" is gradually receiving more and more attention. Accordingly, exploitation and use of renewable energy sources have become a focus of development all over the world. Among the renewable energy sources, solar cells that are capable of converting the solar energy into the electric energy are considered to be the most promising, so numerous manufacturers are now devoted to production of solar cells. Currently, a critical problem related to solar cells is how to improve the photo-electric conversion efficiency thereof, and any Improvement in the photo-elertric conversion efficiency of solar cells will lead to improvement in competitive edge of the solar cell products.

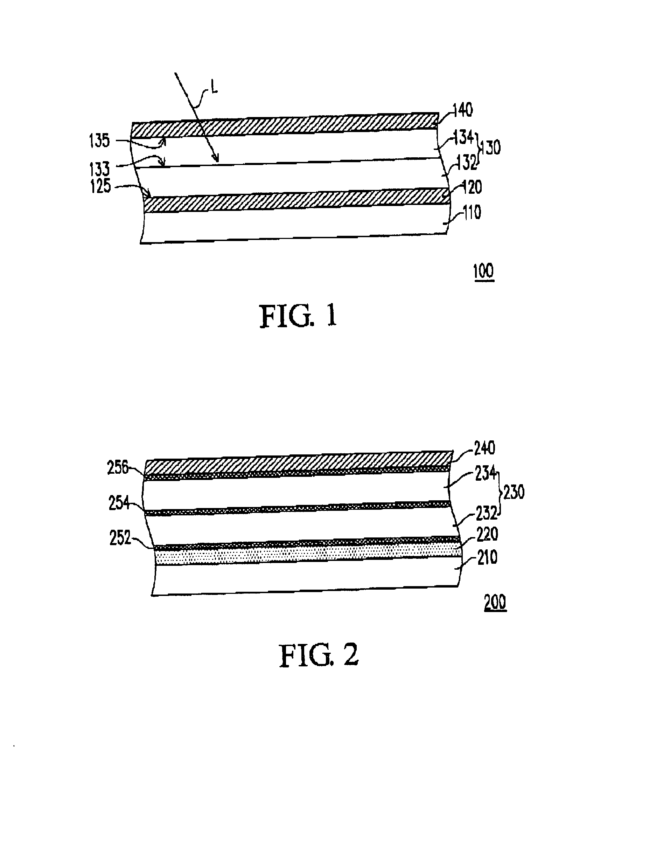

**FIG. 1** is a schematic view of a conventional solar cell. Referring to **FIG. 1****,** the solar cell **100** comprises a substrate **110,** a first conductive layer **120,** a photovoltaic layer **130** and a second conductive layer **140.** The photovoltaic layer **130** has, for example, a P-type doped film **132** and an N-type doped film **134.**

Generally, when a light ray **L** from the outside is irradiated onto the solar cell **100,** electron-hole pairs will be generated by the P-type doped film **132** and the N-type doped film **134** in response to the light ray. Under action of a built-in electric field formed by a p-n junction, the electrons and the holes migrate towards the first conductive layer **120** and the second conductive layer **140** respectively to form a photocurrent, This results in an electric energy storage status. Then if a load circuit or an electronic device is externally connected across the solar cell, the electric energy can be supplied to drive the load circuit or the electronic device.

However, because the P-type doped film **132** or the N-type doped film **134** has a high concentration of defects, the electron-hole pairs tend to experience surface recombination near an interface **133** between the P-type doped film **132** and the N-type doped film **134.** Similarly, at an interface **125** between the photovoltaic layer **130** and the first conductive layer **120** or at an interfaces **133** between the photovoltaic layer **130** and the second conductive layer **140,** the electron-hole pairs also tend to experience surface recombination. When surface recombination of the electron-hole pairs occurs in the solar cell **100,** energy of the light ray **L** absorbed by the photovoltaic layer 130 is converted from the electric energy into heat energy and dissipated. This leads to a degraded photo-electric conversion efficiency of the solar cell **100.**

### SUMMARY OF THE INVENTION

In view of this, the present invention provides a solar cell, which has an improved photo-electric conversion efficiency by reducing the chance of surface recombination of the electron-bole pairs.

The present invention also provides a method for manufacturing a solar cell, with which the aforesaid solar cell can be manufactured.

The solar cell of the present invention comprises a substrate, a first conductive layer, a photovoltaic layer, a second conductive layer and at least one passivation layer. The first conductive layer is disposed on the substrate. The photovoltaic layer is adapted to generate electron-hole pairs when being irradiated by a light ray. The photovoltaic layer is disposed on the first conductive layer and has a plurality of doped films, The second conductive layer is disposed on the photovoltaic layer. The at least one passivation layer is disposed on at least one of the positions between the first conductive layer and the photovoltaic layer, between the doped films in the photovoltaic layer and between the photovoltaic layer and the second conductive layer, so as to reduce the chance of surface recombination of the electron-hole pairs on at least one surface of the photovoltaic layer.

In an embodiment of the present invention, the doped films include a P-type doped film and an N-type doped film, and the doped films are stacked on the first conductive layer.

In an embodiment of the present invention, the P-type doped film is disposed between the first conductive layer and the N-type doped film, or the N-type doped film is disposed between the first conductive layer and the P-type doped film.

In an embodiment of the present invention, the doped films include a plurality of P-type doped films and a plurality of N-type doped films, Each of the P-type doped films and each of the N-type doped films are stacked on the first conductive layer alternately to form a plurality of p-n junctions.

In an embodiment of the present invention, the photovoltaic layer further comprises at least one intrinsic layer disposed between parts of the doped films.

In an embodiment of the present invention, when the at least one passivation layer is disposed between the doped films in the photovoltaic layer, the P-type doped films are disposed between the at least one passivation layer and the at least one intrinsic layer or the N-type doped films are disposed between the at least one passivation layer and the at least one intrinsic layer.

In an embodiment of the present invention, the at least one passivation layer is made of silicon oxide (SiOₓ), silicon nitride (SiNₓ), silicon oxynitride (SiNOₓ) or a combination thereof.

In an embodiment of the present invention, the at least one passivation layer is made of an intrinsic semiconductor material.

In an embodiment of the present invention, the at least one passivation layer has a thickness of 1 Å to 10000 Å.

In an embodiment of the present invention, the at least one passivation layer has a thickness of 10 Å to 1000 Å.

In an embodiment of the present invention, the photovoltaic layer is made of a group IV element semiconductor thin film, a group III-V compound semiconductor thin film, a group II-VI compound semiconductor thin film, an organic compound semiconductor thin film, or a combination thereof.

In an embodiment of the present invention, the group IV element semiconductor thin film comprises at least one of a carbon element thin film, a silicon element thin film, a germanium elemental thin film, a silicon carbide thin film and a germanium silicide thin film, or a combination thereof in a monocrystalline phase, a polycrystalline phase, an amorphous phase or a microcrystalline phase.

In an embodiment of the present invention, the group III-V compound semiconductor thin film comprises at least one of a gallium arsenide (GaAs) compound thin film, an indium gallium phosphide (InGaP) compound thin film, or a combination thereof.

In an embodiment of the present invention, the group II-VI compound semiconductor thin film comprises at least one of a copper indium selenium (CIS) compound thin film, a copper indium gallium selenium (CIGS) compound thin film and a cadmium telluride (CdTe) compound thin film, or a combination thereof.

In an embodiment of the present invention, the organic compound semiconductor thin film comprises a mixture of a conjugated polymer donor and a carbon nanosphere acceptor.

In an embodiment of the present invention, the first conductive layer is made of a transparent conductive layer while the second conductive layer comprises at least one of a reflective layer and a transparent conductive layer; or the second conductive layer is made of a transparent conductive layer while the first conductive layer comprises at least one of a reflective Layer and a transparent conductive layer.

The method for manufacturing a solar cell of the present invention comprises the following steps: providing a substrate; forming a first conductive layer on the substrate; forming, on the first conductive layer, a photovoltaic layer having a plurality of doped films, wherein the photovoltaic layer generates electron-hole pairs when being irradiated by a light ray; forming a second conductive layer on the photovoltaic layer; and farming a passivation layer on at least one of the positions between the first conductive layer and the photovoltaic layer, between the doped films in the photovoltaic layer and between the photovoltaic layer and the second conductive layer, so as to reduce the chance of surface recombination of the electron-hole pairs on at least one surface of the photovoltaic layer.

In an embodiment of the present invention, step of forming the passivation layer comprises forming a native oxide on at least one of the first conductive layer and the second conductive layer.

In an embodiment of the present invention, the native oxide is silicon oxide (SiOₓ).

In an embodiment of the present invention, the step of forming the passivation layer comprises performing a CO₂ plasma process or a deposition process.

In an embodiment of the present invention, the deposition process comprises a plasma enhanced chemical vapor deposition (PECVD) process, a radio frequency plasma enhanced chemical vapor deposition (RF PECVD) process, a very high frequency plasma enhanced chemical vapor deposition (VHF PECVD) process or a microwave plasma enhanced chemical vapor deposition (MW PECVD) process.

According to the above descriptions, the solar cell of the present invention has at least one passivation layer disposed on at least one of the positions between the first conductive layer and the photovoltaic layer, between the doped films in the photovoltaic layer and between the photovoltaic layer and the second conductive layer. This can reduce the chance of surface recombination of the electron-hole pairs to result in an improved photo-electric conversion efficiency of the solar cell. Furthermore, a method for manufacturing a solar cell is also disclosed in the present invention, with which the aforesaid solar cell can be manufactured.

The detailed technology and preferred embodiments Implemented for the subject invention are described in the following paragraphs accompanying the appended drawings for people skilled in this field to well appreciate the features of the claimed invention.

### BRIEF DESCRIPTION OF THE DRAWINGS

**FIG. 1** is a schematic view of a conventional solar cell;
**FIG. 2** is a schematic view of a solar cell according to an embodiment of the present invention;
**FIG. 3** is a schematic view of a solar cell according to another embodiment of the present invention;
**FIG. 4** is a schematic view of a solar cell according to a further embodiment of the present invention; and
**FIGs. 5A** to **5H** illustrate a process of manufacturing a solar cell according to an embodiment of the present invention.

### DESCRIPTION OF THE PREFERRED EMBODIMENT

**FIG. 2** is a schematic view of a solar cell according to an embodiment of the present invention. Referring to **FIG. 2****,** the solar cell **200** comprises a substrate **210,** a first conductive layer **220,** a photovoltaic layer **230,** a second conductive layer **240** and passivation layers **252, 254, 256.** In this embodiment, the substrate **210** is, for example, a transparent substrate such as a glass substrate.

The first conductive layer **220** is disposed on the substrate **210.** In this embodiment, the first conductive layer **220** is a transparent conductive layer, which may be made of at least one of zinc oxide, tin oxide, indium tin oxide (ITO), indium zinc oxide (IZO), indium tin zinc oxide (ITZO), aluminum tin oxide (ATO), aluminum zinc oxide (AZO), cadmium indium oxide (CIO), cadmium zinc oxide (CZO), gallium zinc oxide (GaZO) and tin oxyfluoride.

The photovoltaic layer **230** generates electron-hole pairs when being irradiated by a light ray. The photovoltaic layer **230** is disposed on the first conductive layer **220** and has a P-type doped film **232** and an N-type doped film **234.** That is, the structure of film of the photovoltaic layer **230** is a photo-electric conversion structure of a p-n junction design. In another embodiment that is not shown, the structure of film of the photovoltaic layer **230** may also be a photo-electric conversion structure of a p-i-n junction design, which is comprised of a P-type semiconductor layer, an intrinsic layer and an N-type semiconductor layer.

In this embodiment, the P-type doped film **232** and the N-type doped film **234** are stacked on the first conductive layer **220,** with the P-type doped film **232** being interposed between the first conductive layer **220** and the N-type doped film **234.** Alternatively, in other embodiments, the structure of film of the photovoltaic layer **230** may also have the N-type doped film interposed between the first conductive layer and the P-type doped film.

In this embodiment, films of the photovoltaic layer **230** may be semiconductor thin films formed of a group IV element such as carbon, silicon or germanium, for example, at least one of a carbon element thin film, a silicon element thin film, a germanium element thin film, a silicon carbide thin film and a germanium silicide thin film or a combination thereof in a monocrystalline phase, a polycrystalline phase, an amorphous phase or a microcrystalline phase. In an embodiment, apart from being made of silicon thin films, the photovoltaic layer **230** may also be made of at least one of copper indium gallium selenium (CIGS) and cadmium telluride (CdTa), or a combination thereof, in which case the solar cell **200** of this embodiment will become a CIGS solar cell or a CdTe solar cell.

In another embodiment, the photovoltaic layer **230** may also be made of a material selected from a group III-V compound semiconductor thin film a group II-VI compound semiconductor thin film, an organic compound semiconductor thin film, or a combination thereof For example, the group III-V compound semiconductor thin film includes at least one of a gallium arsenide (GaAs) compound thin film and an indium gallium phosphide (InGaP) compound thin film, or a combination thereof. The group n-VI compound semiconductor thin film comprises at least one of a copper indium selenium (CIS) compound thin film, a copper indium gallium selenium (CIGS) compound thin film and a cadmium telluride (CdTe) compound thin film, or a combination thereof. The organic compound semiconductor thin film comprises a mixture of a conjugated polymer donor and a carbon nanosphere acceptor.

Referring also to **FIG. 2****,** the second conductive layer **240** is disposed on the photovoltaic layer **230.** The second conductive layer **240** may be made of a material described with reference to the aforesaid transparent conductive layer, so no further description will be made thereon herein. In this embodiment, the first conductive layer **220** and the second conductive layer **240** are, for example, both transparent conductive layers. In another embodiment not shown, the second conductive layer **240** may also be a stack formed by a reflective layer and the aforesaid transparent conductive layer. The reflective layer may be disposed between the transparent conductive layer and the substrate **210,** and be made of a metal with desirable reflectivity such as aluminum (Al), silver (Ag), molybdenum (Mo) or copper (Cu). In other words, the design in terms of this may be varied depending on different requirements of users (e.g., depending on whether the solar cell to be fabricated is to receive light on both surfaces or on only a single surface), and what described above is only for illustration purpose but is not to limit the present invention.

The passivation layer **252** is disposed between the first conductive layer **220** and the photovoltaic layer **230,** the passivation layer **254** is disposed between the P-type doped film **232** and the N-type doped film **234** in the photovoltaic layer **230,** and the passivation layer **252** is disposed between the photovoltaic layer **230** and the second conductive layer **240** with an aim to reduce the chance of recombination of the electron-hole pairs on surfaces of the photovoltaic layer **230.** In detail, it is likely that dangling bonds exist on interfaces between the layers **220, 230, 240** or defects (e.g., dislocations, grain boundarles, and point defects) exist in these layers per se. Through disposition of the passivation layers **252, 254, 256** between the layers **220, 230, 240,** the number of the dangling bonds on the interfaces or the defects in the surfaces of these layers can be decreased. Thus, the chance that the electrons and holes experience recombination on the surfaces of the layers **220, 230** and **240** gets lowered because the electrons and holes will not be bonded to such dangling bonds or defects. It shall be noted that, although the solar cell is shown to have three passivation layers **252, 254, 256** located at different positions, this is only shown for illustration purpose and the present invention has no limitation on the number of the passivation layers. In other embodiments, there may be disposed only one or two of the passivation layers **252, 254, 256** depending on requirements in practical use.

In this embodiment, the passivation layers 252, 254, 256 may be made of silicon oxide (SiOₓ), silicon nitride (SiNₓ), silicon oxynitride (SiNOₓ) or a combination thereof. In another embodiment, the passivation layers **252, 254, 256** may also be made of an intrinsic semiconductor material. It shall be appreciated that, albeit of the aforesaid benefits provided by the passivation layers **252, 254, 256,** too thick passivation layers may increase the electrical resistance of the solar cell. Therefore, it is important to choose appropriate thicknesses of the passivation layers, and the thicknesses may vary depend on materials of the passivation layers. In this embodiment, the passivation layers **252, 254, 256** may have a thickness of 1 Å to 10000 Å. More particularly, in a preferred embodiment, the passivation layers **252, 254, 256** may have a thickness of 10 Å to 1000 Å, which can effectively improve the electrical performance of the solar cell **200.**

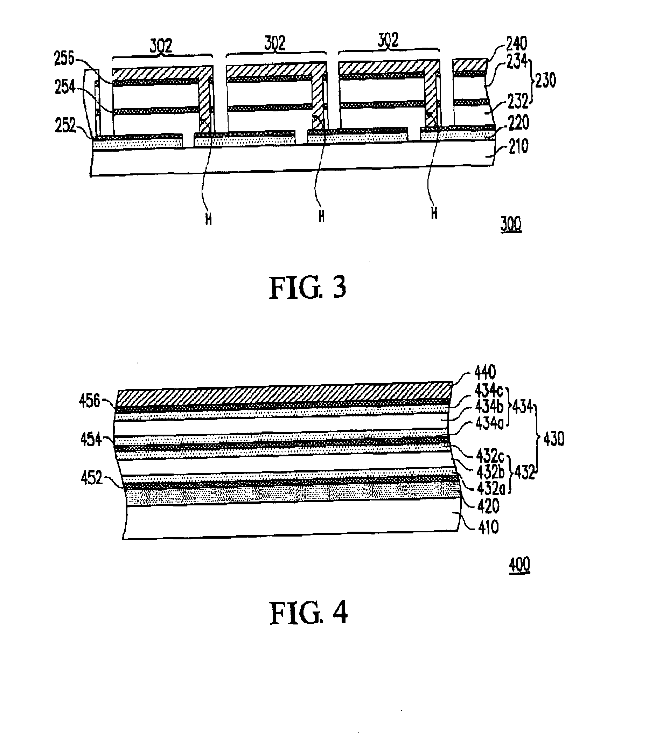

**FIG. 3** is a schematic view of a solar cell according to another embodiment of the present invention. Referring to **FIG. 3****,** the solar cell **300** comprises all the members of the aforesaid solar cell **200.** For these identical members, they will be denoted with identical reference numerals and will not be further described again herein.

Particularly, the solar cell **300** is of a solar cell structure comprised of a plurality of sub-cells **302** in electrical tandem with each other. The second conductive layer **240** of each of the sub-cells **302** is electrically connected with the first conductive layer **220** of an adjacent sub-cell **302** through an opening H. With the passivation layers **252, 254, 256** disposed therein, the solar cell **300** can also achieve the same objectives and functionalities as the solar cell **200.**

**FIG. 4** is a schematic view of a solar cell according to a further embodiment of the present invention. Referring to **FIG. 4****,** the solar cell **400** comprises a substrate **410,** a first conductive layer **420,** a photovoltaic layer **430,** a second conductive layer **440** and passivation layers **452, 454, 456**.

The first conductive layer **420** is disposed on the substrate **410.** The photovoltaic layer **430** generates eleciron-hole pairs when being irradiated by a light ray. The photovoltaic layer **430** is disposed on the first conductive layer **420** and has a plurality of doped films. In this embodiment, the photovoltaic layer **430** may have a first photovoltaic sub-layer **432** and a second photovoltaic sub-layer **434.** For example, the first photovoltaic sub-layer **432** is made of an amorphous silicon thin film and the second photovoltaic sub-layer **434** is made of a microcrystalline silicon thin film. In other embodiments, the photovoltaic layer **430** may also be a stack structure comprised of three or more sub-layers; and what described above is only for illustration purpose and the present invention has no limitation on the number of the photovoltaic sub-layers in the solar cell.

The first photovoltaic sub-layer **432** comprises, for example, a P-type doped film 432a, an intrinsic layer **432b** and an N-type doped film **432c**. The second photovoltaic sub-layer **434** comprises, for example, a P-type doped film **434a,** an intrinsic layer **434b** and an N-type doped film **434c.** In other words, the first photovoltaic sub-layer **432** and the second photovoltaic sub-layer **434** of the photovoltaic layer **430** are in electrical tandem with each other to form a tandem junction structure. Particularly, the P-type doped films **432a, 434a** and the N-type doped films **432c, 434c** are, for example, alternately stacked on the first conductive layer **420** to form a plurality of p-n junctions. In some embodiments, the first photovoltaic sub-layer **432** may also not be provided with the intrinsic layer **432b,** or the second photovoltaic sub-layer **434** may not be provided with the intrinsic layer **434b.** In other words, one of the first photovoltaic sub-Layer **432** and the second photovoltaic sub-layer **434** may be a photo-electric conversion structure of a p-n junction design, while the other may be a photo-electric conversion structure of a p-i-n junction design.

The second conductive layer **440** is disposed on the photovoltaic layer **430.** The passivation layer **452** is disposed between the first conductive layer **420** and the photovoltaic layer **430,** the passivation layer **454** is disposed between the N-type doped film **432c** of the first photovoltaic sub-layer **432** and the P-type doped film **434a** of the second photovoltaic sub-layer **434,** and the passivation **456** is disposed between the photovoltaic layer **430** and the second conductive layer **440** with an aim to reduce the chance of surface recombination of the electron-hole pairs on at least one surface of the photovoltaic layer **430.** Similarly, in other embodiments of the solar cell, there may be disposed only one or two of the passivation layers **452, 454, 456.**

In this embodiment, the passivation layers **452, 454, 456** are disposed, for example, between the plurality of doped films of the photovoltaic layer **430.** More specifically, the P-type doped film **432a** of the first photovoltaic sub-layer **432** is disposed between the passivation layer **452** and the intrinsic layer **432b,** and the P-type doped film **434a** of the second photovoltaic sub-layer **434** is disposed between the passivation layer **454** and the intrinsic layer **434b.** Additionally, the N-type doped film **432c** of the first photovoltaic sub-layer **432** is disposed between the passivation layer **454** and the intrinsic layer **432b,** and the N-type doped film **434c** of the second photovoltaic sub-layer **434** is disposed between the passivation layer **456** and the intrinsic layer **434b.** With the passivation layers **452, 454, 456** disposed therein, the solar cell **400** can also achieve the same objectives and functionalities as the solar cell **200**.

As can be known from the above embodiments, solar cells where a passivation layer(s) is disposed between a conductive layer and a photovoltaic layer or between a plurality of doped films of the photovoltaic layer to reduce the chance of surface recombination of electron-hole pairs shall all fall within the spirits and scope of the present invention.

Hereinbelow, a method for manufacturing the solar cell **200** will be described.

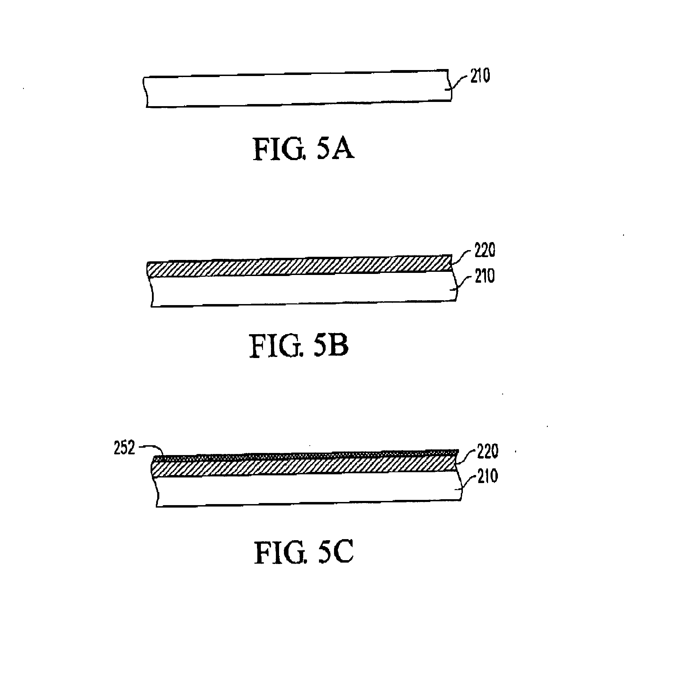

**FIGs. 5A** to **5H** illustrate a process of manufacturing a solar cell according to an embodiment of the present invention. Firstly, referring to **FIG. 5A****,** a substrate **210** is provided. For example, the substrate **210** is a glass substrate.

Then, referring to **FIG. 5B****,** a first conductive layer **220** is formed on the substrate **210,** In this embodiment, the first conductive layer **220** may be the aforesaid transparent conductive layer and formed through, for example, a sputtering process, a metal organic chemical vapor deposition (CVD) process or an evaporation process.

Nex§ referring to **FIG. 5C****,** a passivation layer **252** is formed on the fust conductive layer **220.** In this embodiment, the passivation layer **252** may be formed by, for example, leaving the first conductive layer **220** still in the air for a period of time to form a native oxide. In another embodiment, the passivation layer **252** may also be formed by performing a CO₂ plasma process to form a SiOₓ thin film on the first conductive layer **220,** or by performing a deposition process to form an intrinsic silicon thin film on the first conductive layer **220.** Here, the deposition process may be a plasma enhanced chemical vapor deposition process, a radio frequency plasma enhanced chemical vapor deposition (RF PECVD) process, a very high frequency plasma enhanced chemical vapor deposition (VHF PECVD) process or a microwave plasma enhanced chemical vapor deposition (MW PECVD) process.

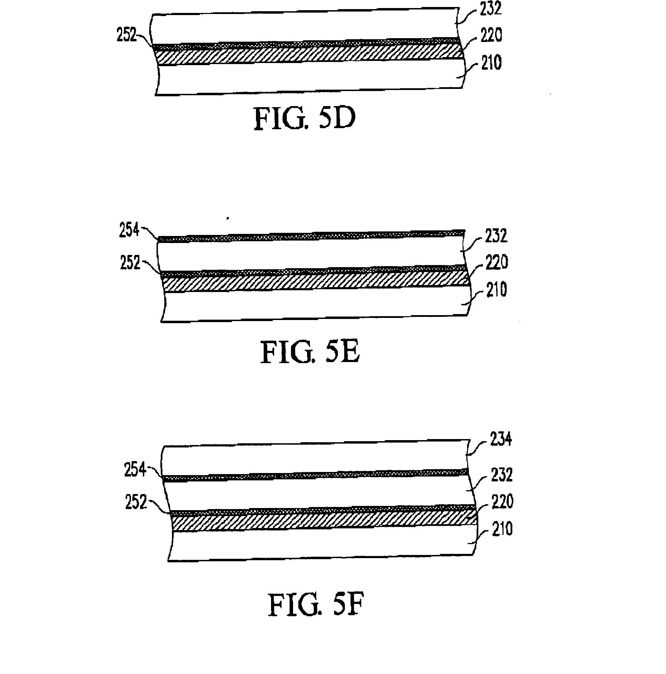

Subsequently, referring to **FIG. 5D****,** a P-type doped film **232** is formed on the passivation layer **252,** In this embodiment, the P-type doped film **232** is formed by, for example, performing the aforesaid deposition process on the passivation layer **252** to form an amorphous silicon or microcrystalline silicon thin film and then, or in-situ, performing a doping process to introduce a P-type dopant into the amorphous silicon or microcrystalline silicon thin film. The P-type dopant is, for example, a group III element More specifically, the doping process may be performed by an in-situ doping during deposition or by a furnace diffusion unit or an ion implantation unit.

Thereafter, referring to **FIG. 5E****,** a passivation layer **254** is formed on the P·type doped film **232.** In this embodiment, the passivation layer **254** may be formed by, for example, forming a native oxide on the P-type doped film **232.** The native oxide may be, for example, silicon oxide. Alternatively, the passivation layer **254** may be formed in other ways as described with reference to the passivation layer **252.**

Next, referring to **FIG. 5F****,** an N-type doped film **234** is formed on the passivation layer **254.** Here, the way in which the N-type doped film **234** is formed is substantially similar to that of the P-type doped film **232.** For example, the deposition process as described above is performed on the passivation layer **254** to form an amorphous silicon or microcrystalline silicon thin film, and then, or at the same time, a doping process is performed to introduce an N-type dopant into the amorphous silicon or microcrystalline silicon thin film. The N-type dopant is, for example, a group V element.

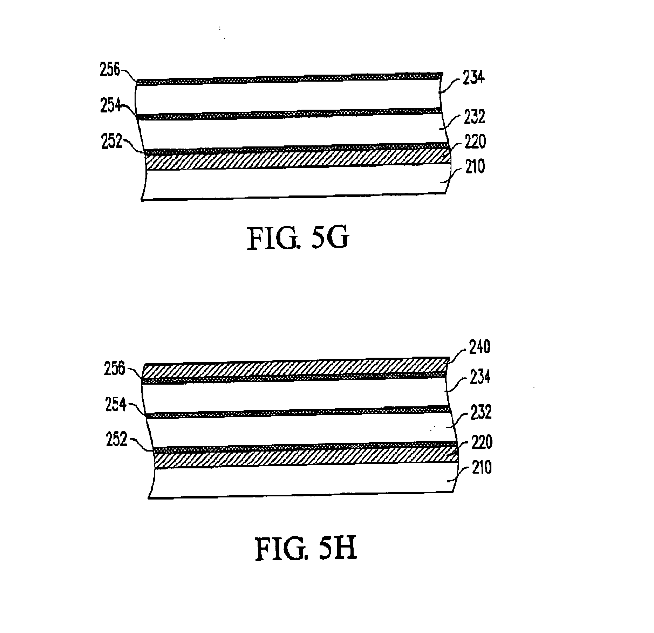

Afterwards, referring to **FIG. 5G****,** a passivation layer **256** is formed on the N-type doped film **234.** In this embodiment, the way in which the passivation layer **256** is formed is substantially similar to those of the passivations **252, 254,** so no further description will be made thereon again.

Finally, referring to **FIG. 5H****,** a second conductive layer **240** is formed on the passivation layer **256.** In this embodiment, the second conductive layer **240** is formed through, for example, the sputtering process, the MOCVD process or the evaporation process described above and is made of, for example, the aforesaid transparent conductive layer. Hence, this will not be bribes described again herein. Thus, the process of manufacturing the solar cell **200** shown in **FIG. 2** is completed.

It shall be emphasized that, the aforesaid manufacturing method is only described as an example, and in some embodiments, the chance of recombination of the electron-hole pairs on the surfaces of the photovoltaic layer **230** may also be reduced by selectively farming only one or two of the passivation layer **252** between the first conductive layer **220** and the photovoltaic layer **230,** the passivation layer **254** between the P-type doped film **232** and the N-type doped film **234** and the passivation layer **256** between the photovoltaic layer **230** and the second conductive layer **240.** Furthermore, in other possible embodiments, a solar cell where the photovoltaic layer is of a tandem junction structure, a triple junction structure or has more than three junctions may also be manufactured through a manufacturing method similar to what described above.

As described above, because the solar cell of the present invention has a passivation layer(s) disposed on at least one of the positions between the conductive layers and the photovoltaic layer and between the plurality of doped films, the chance of surface recombination of the electron-hole pairs gets reduced, In other words, the solar cell of the present invention can present an improved photo-electric conversion efficiency. In addition, the method for manufacturing a solar cell of the present invention can form the passivation layer(s) in the solar cell through a simplified process, thereby improving the performance of the resulting solar cell.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A solar cell, comprising:
a substrate;
a first conductive layer disposed on the substrate;
a photovoltaic layer for generating electroii-hole pairs when being irradiated by a light
ray, wherein the photovoltaic layer is disposed on the first conductive layer and has a plurality of doped films;
a second conductive layer disposed on the photovoltaic layer; and
at least one passivation layer, disposed on at least one of the positions between the first
conductive layer and the photovoltaic layer, between the doped films in the photovoltaic layer and between the photovoltaic layer and the second conductive layer, so as to reduce the chance of surface recombination of the electron-hole pairs on at least one surface of the photovoltaic layer.

2. The solar cell as claimed in claim 1, wherein the doped films include a P-type doped film and an N-type doped film, and the doped films are stacked on the first conductive layer.

3. The solar cell as claimed In claim 2, wherein the P-type doped film is disposed between the first conductive layer and the N-type doped film, or the N-type doped film is disposed between the first conductive layer and the P-type doped film.

4. The solar cell as claimed in claim 2, wherein the photovoltaic layer further comprises an intrinsic layer disposed between the P-type doped film and the N-type doped film.

5. The solar cell as claimed in claim 1, wherein the doped films include a plurality of P-type doped films and a plurality of N-type doped films, each of the P-type doped films and each of the N-type doped films are stacked on the first conductive layer alternately to form a plurality of p-n junctions, the photovoltaic layer further comprises at least one intrinsic layer disposed between parts of the doped films, and when the at least one passivation layer is disposed between the doped films in the photovoltaic layer, the P-type doped film are disposed between the at least one passivation layer and the at least one intrinsic layer or the N-type doped films are disposed between the at least one passivation layer and the at least one intrinsic layer,

6. The solar cell as claimed in claim 1, wherein the at least one passivation layer is made of silicon oxide (SiOₓ), silicon nitride (SiNₓ, silicon oxynitride (SiNOₓ), or a combination thereof.

7. The solar cell as claimed in claim 1, wherein the at least one passivation layer is made of an intrinsic semiconductor material.

8. The solar cell as claimed in claim 1, wherein the at least one passivation layer has a thickness of 1 Å to 10000 Å.

9. The solar cell as claimed in claim 1, wherein the photovoltaic layer is made of a group IV element semiconductor thin film, a group III-V compound semiconductor thin film, a group II-VI compound semiconductor thin film, an organic compound semiconductor thin film, or a combination thereof, the group IV element semiconductor thin film comprises at least one of a carbon element thin film, a silicon element thin film, a germanium elemental thin film, a silicon carbide thin film and a germanium silicide thin film, or a combination thereof in a monocrystalline phase, a polycrystalline phase, an amorphous phase or a microcrystalline phase, the group III-V compound semiconductor thin film comprises at least one of a gallium arsenide (GaAs) compound thin film and an indium gallium phosphide (InGaP) compound thin film, or a combination thereof, and group II-VI compound semiconductor thin film comprises at least one of a copper indium selenium (CIS) compound thin film, a copper indium gallium selenium (CIGS) compound thin film and a cadmium telluride (CdTe) compound thin film, or a combination thereof.

10. The solar cell as claimed in claim 9, wherein the organic compound semiconductor thin film comprises a mixture of a conjugated polymer donor and a carbon nanosphere acceptor.

11. The solar cell as claimed in claim 1, wherein the fast conductive layer is made of a
transparent conductive layer while the second conductive layer comprises at least one of a reflective layer and a transparent conductive layer, or the second conductive layer is made of a transparent conductive layer while the first conductive layer comprises at least one of a reflective layer and a transparent conductive layer.

12. A method for manufacturing a solar cell, comprising:
providing a substrate;
forming a first conductive layer on the substrate;
forming, on the first conductive layer, a photovoltaic layer having a plurality of doped films, wherein the photovoltaic layer generates electron-hole pairs when being irradiated by a light ray;
forming a second conductive layer on the photovoltaic layer; and
forming a passivation layer on at least one of the positions between the first conductive layer and the photovoltaic layer, between the doped films in the photovoltaic layer and between the photovoltaic layer and the second conductive layer, so as to reduce the chance of surface recombination of the electron-bole pairs on at least one surface of the photovoltaic layer.

13. The method for manufacturing a solar cell as claimed in claim 12, wherein the step of forming the passivation layer comprises a step of forming a native oxide on at least one of the first conductive layer and the second conductive layer, performing a CO₂ plasma process, and performing a deposition process.

14. The method for manufacturing a solar cell as claimed in claim 12, wherein the native oxide is silicon oxide (SiOₓ).

15. The method for manufacturing a solar cell as claimed in claim 13, wherein the deposition process comprises a plasma enhanced chemical vapor deposition process, a radio frequency plasma enhanced chemical vapor deposition (RF PECVD) process, a very high frequency plasma enhanced chemical vapor deposition (VHF PECVD) process or a microwave plasma enhanced chemical vapor deposition (MW PECVD) process.
